(19) Europäisches Patentamt
European Patent Office
Office européen des brevets

(11) EP 4 521 891 A1

(12) DEMANDE DE BREVET EUROPEEN

(43) Date de publication:
**12.03.2025 Bulletin 2025/11**

(21) Numéro de dépôt: **24197444.3**

(22) Date de dépôt: **30.08.2024**

(51) Classification Internationale des Brevets (IPC):
**H10H 29/01** (2025.01)    **H10H 20/815** (2025.01)
**H10H 29/30** (2025.01)    **H10H 20/817** (2025.01)

(52) Classification Coopérative des Brevets (CPC):
**H10H 20/815; H10H 20/817; H10H 29/012;
H10H 29/30;** H10H 20/825

(84) Etats contractants désignés:
**AL AT BE BG CH CY CZ DE DK EE ES FI FR GB
GR HR HU IE IS IT LI LT LU LV MC ME MK MT NL
NO PL PT RO RS SE SI SK SM TR**
Etats d'extension désignés:
**BA**
Etats de validation désignés:
**GE KH MA MD TN**

(30) Priorité: **08.09.2023 FR 2309451**

(71) Demandeur: **Commissariat à l'Energie Atomique
et aux Energies
Alternatives
75015 Paris (FR)**

(72) Inventeurs:
• **AVENTURIER, Bernard
38054 GRENOBLE CEDEX 09 (FR)**

• **DOUMA, Marion
38054 GRENOBLE CEDEX 09 (FR)**
• **LEVY, François
38054 GRENOBLE CEDEX 09 (FR)**
• **PERNEL, Carole
38054 GRENOBE CEDEX 09 (FR)**
• **AUDIBERT, Margaux
38054 GRENOBLE CEDEX 09 (FR)**
• **MEDJAHED, Ilyes
38054 GRENOBLE CEDEX 09 (FR)**

(74) Mandataire: **Cabinet Beaumont
4, Place Robert Schuman
B.P. 1529
38025 Grenoble Cedex 1 (FR)**

(54) **PROCÉDÉ DE POROSIFICATION DE MESAS (AL,IN,GA)N/(AL,IN,GA)N**

(57)    La présente description concerne un procédé de porosification d'une structure (100) comprenant un substrat de base (110) recouvert de mésas (120) (Al,In,Ga)N/(Al,In,Ga)N, comprenant une étape de porosification au cours de laquelle on porosifie par voie électrochimique les mésas (Al,In,Ga)N/(Al,In,Ga)N, lors de l'étape de porosification, la structure (100) comprend, en outre, entre les mésas (120) ou entre des groupes de mésas (120), des lignes électriquement conductrices (200) recouvertes par un élément électriquement isolant (300).

Fig 3A

EP 4 521 891 A1

## Description

### Domaine technique

La présente description concerne de façon générale le domaine général des micro-écrans couleur, et notamment le domaine des micro-écrans couleur à base de micro-LEDs.

L'invention concerne un procédé pour porosifier des mésas (Al,In,Ga)N/(Al,In,Ga)N.

L'invention concerne également une structure ainsi obtenue comprenant des mésas (Al,In,Ga) N/(Al,In,Ga)N porosifiées.

### Technique antérieure

Les micro-écrans couleurs comprennent des pixels formés de sous-pixels bleus, verts et rouges (pixels RGB). Dans la suite de la description, ces sous-pixels seront désignés plus simplement pixel par souci de concision.

Les pixels bleus et verts peuvent être fabriqués à base de matériaux nitrures et les pixels rouges à base de matériaux phosphures. Pour combiner sur le même substrat ces trois types de pixels, la technique dite de « pick and place » est généralement utilisée. Cependant, dans le cas des micro-écrans avec des pixels inférieurs à 10 μm, cette technique ne peut plus être utilisée à cause, non seulement, des problèmes d'alignement, mais aussi du temps nécessaire pour réaliser une telle technique à cette échelle. Pour les écrans avec un grand nombre de pixels (définition élevée), cette technique de « pick and place » est problématique en terme de temps. De plus il faut prélever les pixels sur des plaques ('wafer') différents, ce qui nécessite des transferts successifs. Des techniques de transfert en parallèle peuvent également être utilisées ('mass transfert').

Une autre solution consiste à réaliser la conversion de couleurs avec des boîtes quantiques (QD pour « Quantum Dot » en langue anglaise) ou des nanophosphores pompés par des pLEDs bleues issues d'une seule plaque ('wafer'), soit reportés, soit dans une matrice monolithique (cas préféré pour les micro-écrans). Cependant, le contrôle du dépôt de ces matériaux sur des pixels de faibles dimensions est difficile et leur tenue au flux n'est pas suffisamment robuste.

Il est donc crucial de pouvoir obtenir les trois pixels RGB de façon native avec la même famille de matériaux et dont la croissance est réalisée sur le même substrat. Pour cela, l'InGaN est le matériau le plus prometteur. Ce matériau peut, en effet, théoriquement couvrir tout le spectre visible en fonction de sa concentration en indium. Les micro-LEDs bleues à base d'InGaN montrent déjà une luminance élevée, bien supérieure à leurs homologues organiques. Pour émettre à des longueurs d'onde dans le vert, les puits quantiques (PQs) de la LED doivent contenir au moins 25% d'indium et pour une émission dans le rouge, il est nécessaire d'avoir au moins 35% d'indium. Malheureusement, la qualité du matériau InGaN au-delà de 20% d'In est dégradée en raison de la faible miscibilité de l'InN dans le GaN, mais aussi en raison de la forte contrainte compressive inhérente à la croissance de la zone active InGaN sur GaN.

Il est donc essentiel de pouvoir réduire la contrainte globale dans les structures à base de GaN/InGaN.

Actuellement, une des solutions les plus prometteuses consiste à porosifier la couche de GaN, comme décrit par exemple, dans les deux articles de Pasayat et al. (Materials 2020, 13, 213 ; Appl. Phys. Lett. 116 111101 (2020)). Le procédé décrit dans ces articles comprend les étapes suivantes :

- fournir un empilement comprenant un substrat en saphir recouvert par une couche de GaN non intentionnellement dopée (GaN nid), une couche de GaN dopée Si n+ ($5e10^{18}$ at/cm$^3$) et une couche d'InGaN ou de GaN non intentionnellement dopée,

- graver partiellement l'empilement pour former les mésas GaN/InGaN ou GaN/GaN ; l'épaisseur de la couche dopée n'est gravée que partiellement pour que la couche dopée résiduelle en fond de mésa permette la polarisation de la couche dopée de toutes les mésas ('polarisation ring' ou polarisation bord de plaque, par exemple)

- réaliser une étape de porosification électrochimique dans une solution d'acide oxalique (0,3M), la couche de GaN dopée jouant le rôle d'anode et un fil de platine jouant le rôle de cathode.

La couche porosifiée de GaN ainsi obtenue peut permettre de faire croître une structure LED nitrure à base d'InGaN de meilleure qualité cristalline, grâce à la relaxation des mesas poreux générés.

Cependant, la qualité de la LED dépend non seulement du diamètre des pores et de la porosité de la couche de GaN porosifiée. Il est donc nécessaire de pouvoir porosifier de manière homogène toutes les mésas d'une même plaque.

Il est également possible d'avoir une couche commune à toutes les mésas dans ces empilements. L'étape de porosification est alors réalisée en polarisant cette couche commune avec un potentiel anodique.

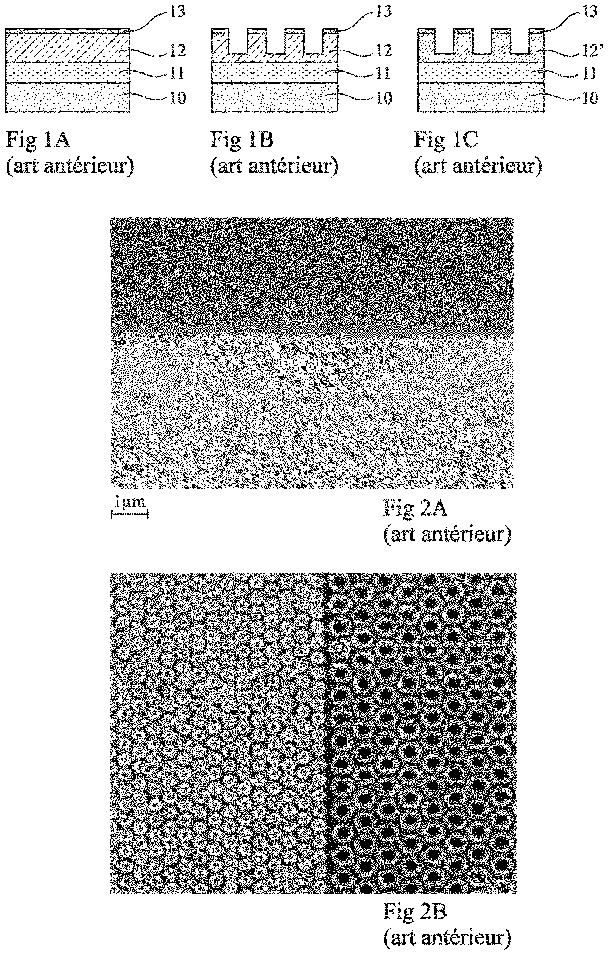

Par exemple, les figures 1A à 1C représentent différentes étapes d'un tel procédé. Plus particulièrement, le procédé comprend les étapes suivantes :

- fournir un empilement comprenant successivement une couche support 10, une couche GaN non intentionnellement dopée 11, une couche GaN dopée ou fortement dopée 12, une couche d'InGaN ou de GaN nid 13 (figure 1A),
- structurer des mésas dans cet empilement, les mésas comprenant la couche d'InGaN ou de GaN nid 13 et une partie de la couche GaN dopée ou fortement dopée 12 (figure 1B), l'autre partie de la couche GaN dopée jouant le rôle de couche commune aux mésas,

- plonger la structure obtenue dans une solution électrolytique et appliquer une tension entre la couche GaN dopée ou fortement dopée 12 et une contre-électrode, moyennant quoi on obtient une couche GaN porosifiée 12' (figure 1C).

Il est connu que les couches d'InGaN nid ont des défauts intrinsèques ('V-pits'), ce qui facilite la porosification des mésas car la solution électrolytique peut s'infiltrer à partir de cette couche supérieure 13 des mésas jusqu'à la couche dopée ou fortement dopée 12 à travers ces défauts en même temps que par les flancs de la couche dopée ou fortement dopée des mésas 12.

Cependant, les couches de GaN nid ne présentent pas de tels défauts : ce sont des couches denses. Ainsi, dans la configuration GaN/GaN, la couche dopée ou fortement dopée des mésas 12 se porosifie à partir des flancs de mésas vers le centre des mésas. Cette couche ne se porosifie pas entièrement jusqu'au centre des mésas. Des effets bord/centre de la plaque ('wafer') sont observés, par exemple sur des plaques 2 pouces. Les figures 2A et 2B représentent les mésas du centre d'une telle structure, après porosification, en coupe et en vue de dessus respectivement. Les mésas sont très partiellement porosifiées.

Cet effet peut être dû à la dégradation de la conductivité latérale de la couche dopée résiduelle de fond de mésa, la polarisation se faisant par la périphérie de la plaque ('wafer') d'où l'effet bord / centre de la plaque.

Il existe donc un réel besoin d'avoir un procédé permettant de porosifier entièrement les mésas et de limiter les effets bord centre sur les plaques, notamment sur des plaques de 2 pouces (5,08cm) et d'autant plus sur des plaques de plus grandes dimensions (200mm et 300mm).

Résumé de l'invention

Il existe un besoin de proposer un procédé de porosification de mésas (Al,In,Ga)N/(Al,In,Ga)N permettant de porosifier de manière identique (ou homogène) toutes les mésas sur la plaque ('wafer'), qu'elles soient en bord ou au centre de la plaque, le procédé devant être avantageusement, utilisable même pour de grands substrats (typiquement sur des substrats d'au moins 5 cm et de préférence d'au moins 10cm de diamètre).
Ce but est atteint par un procédé de porosification d'une structure comprenant un substrat de base recouvert de mésas (Al, In, Ga) N/ (Al, In, Ga) N,

le procédé comprenant une étape de porosification au cours de laquelle on porosifie par voie électrochimique les mésas (Al,In,Ga)N/(Al,In,Ga)N,

lors de l'étape de porosification, des lignes électriquement conductrices recouvertes par un élément électriquement isolant étant disposées sur le substrat de base entre les mésas ou entre des groupes de mésas.

Selon un mode de réalisation avantageux, le substrat de base comprend une couche support, une première couche de GaN non dopée, une deuxième couche de GaN dopée.

De préférence, les mésas (Al,In,Ga) N/(Al,In,Ga)N comprennent une troisième couche de (Al,In,Ga)N fortement dopée et une quatrième couche de (Al,In,Ga)N non dopée ou faiblement dopée. Une partie de la deuxième couche de GaN dopée se prolongent dans les mésas. Lors de l'étape de porosification, les lignes électriquement conductrices sont en contact direct avec la deuxième couche de GaN dopée.

La troisième couche de (Al,In,Ga)N fortement dopée des mésas est porosifiée lors de l'étape de porosification. La troisième couche de (Al,In,Ga)N fortement dopée des mésas peut être porosifiée en partie ou toalement lors de l'étape de porosification.

Selon une variante avantageuse, les lignes électriquement conductrices sont en un métal, de préférence en titane, ou en un polymère conducteur.

Selon une autre variante avantageuse, les lignes électriquement conductrices sont en GaN fortement dopé.

Selon cette autre variante avantageuse, le procédé peut comprendre une étape au cours de laquelle les lignes électriquement conductrices sont formées par épitaxie.

Avantageusement, les lignes électriquement conductrices forment une grille.

Avantageusement, les lignes électriquement conductrices recouvrent localement le substrat de base et l'espace entre les lignes électriquement conductrices et les mésas est compris entre 100 nm et 1 $\mu$m, de préférence entre 200 nm et 500 nm.

Un mode de réalisation prévoit une structure comprenant un substrat de base recouvert de mésas (Al,In,Ga)N/(Al,In,Ga)N porosifiées. La structure comprend, en outre, des lignes électriquement conductrices, recouvertes par un élément électriquement isolant, disposées sur le substrat de base entre les mésas ou entre des groupes de mésas.

Avantageusement, le substrat de base comprend une couche support, une première couche de GaN non dopée et une deuxième couche de GaN dopée.

De préférence, les mésas (Al,In,Ga) N/(Al,In,Ga)N comprennent une troisième couche de GaN fortement dopée porosifiée et une quatrième couche de (Al,In,Ga)N non dopée ou faiblement dopée. Une partie de la deuxième couche de GaN dopée se prolonge dans les mésas.

La troisième couche de (Al,In,Ga)N fortement dopée des mésas peut être porosifiée en partie ou toalement.

Selon un mode de réalisation, les lignes électriquement conductrices sont en GaN fortement dopé, en métal ou en polymère conducteur.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

les figures 1A, 1B et 1C, précédemment décrites, représentent, de manière schématique différentes étapes d'un procédé de porosification selon l'art antérieur;

la figure 2A, précédemment décrite, est un cliché obtenu au microscope électronique à balayage d'une mésa (Al,In,Ga)N/(Al,In,Ga)N, selon l'art antérieur, après l'étape de porosification : la porosification est incomplète,

la figure 2B, précédemment décrite, est un cliché obtenu au microscope optique en fond noir de différentes mésas (Al,In,Ga)N/(Al,In,Ga)N, en vue de dessus, selon l'art antérieur, après l'étape de porosification, au niveau du centre de la plaque ; la partie à gauche des figures correspond à des mésas (Al,In,Ga)N/(Al,In,Ga)N de 3 $\mu$m de largeur et la partie à droite des figures correspond à des mésas (Al,In,Ga)N/(Al,In,Ga)N de 5pm de largeur,

les figures 3A, 3B, 3C représentent de manière schématique différentes étapes d'un procédé de porosification de mésas selon un mode de réalisation particulier de l'invention ;

la figure 4 représente, de manière schématique et en coupe, une structure comprenant des mésas (Al,In,Ga)N/(Al,In,Ga)N porosifiées et des lignes électriquement conductrices, selon un mode de réalisation de l'invention,

les figures 5A, 5B, 5C, 5D représentent de manière schématique différentes étapes d'un procédé de fabrication d'une grille en métal selon un mode de réalisation particulier de l'invention ;

les figures 6A, 6B, 6C, 6D représentent de manière schématique différentes étapes d'un procédé de fabrication d'une grille en métal selon un autre mode de réalisation particulier de l'invention ;

les figures 7A, 7B, 7C représentent de manière schématique différentes étapes d'un procédé pour recouvrir une grille en métal par un élément électriquement isolant selon un mode de réalisation particulier de l'invention ; et

les figures 8A, 8B, 8C, 8D et 8E représentent de manière schématique différentes étapes d'un procédé de fabrication d'une grille en GaN fortement dopé, recouverte par un élément électriquement isolant, selon un mode de réalisation particulier de l'invention. Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

Bien que cela ne soit aucunement limitatif, l'invention trouve particulièrement des applications dans le domaine des micro-écrans couleurs, et plus particulièrement pour la fabrication des pixels rouge vert bleu. Cependant, elle pourrait être utilisée dans le domaine du photovoltaïque ou encore de l'électrolyse de l'eau (« water splitting ») puisque, d'une part, l'InGaN absorbe dans tout le spectre visible et que, d'autre part, ses bandes de valence et de conduction sont autour du domaine de stabilité de l'eau, condition thermodynamique nécessaire à la réaction de décomposition de l'eau. L'invention peut également être intéressante pour la fabrication de LED ou de laser émettant à grande longueur d'onde.

Le procédé est particulièrement intéressant pour fabriquer des structures comprenant des mésas (Al,In,Ga)N/(Al,In,Ga)N porosifiées ayant, notamment, un pas inférieur à 30 $\mu$m.

Par (Al,In,Ga)N, on entend AlN, AlGaN, InGaN ou GaN. Par la suite, on fait plus particulièrement référence à du GaN poreux, mais avec un tel procédé, il est possible d'avoir, par exemple, de l'InGaN ou du AlGaN poreux. La couche dense en InGaN (en compression) ou la couche dense en AlGaN (en tension) va se relaxer grâce à une structure poreuse quelle que soit sa composition.

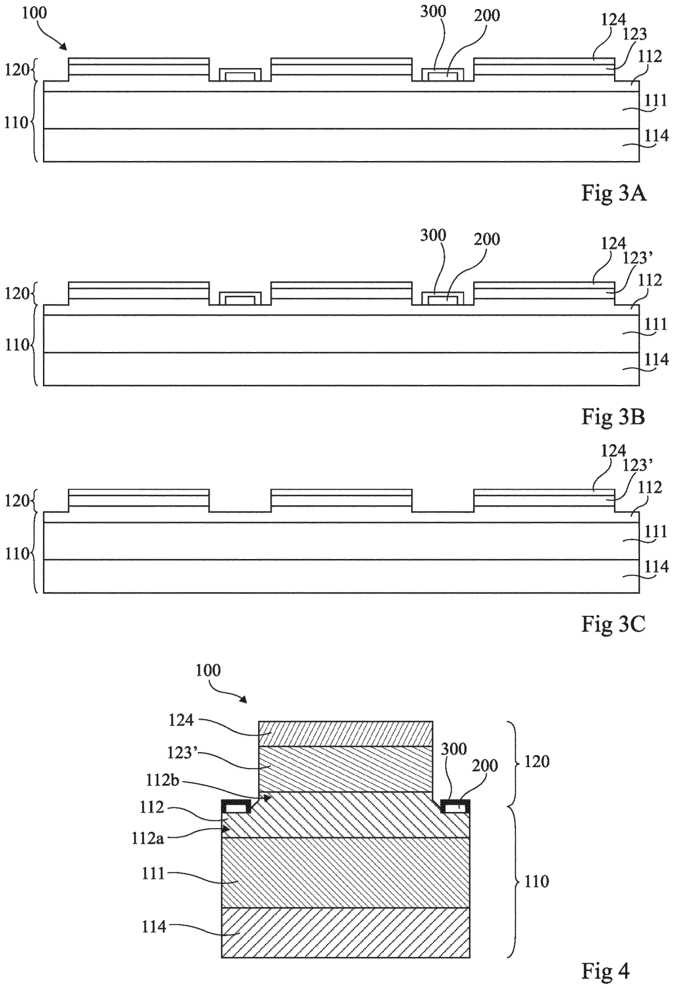

En faisant référence aux figures 3A, 3B et 3C, nous allons maintenant décrire plus en détail le procédé de porosification de mésas 120 de (Al,In,Ga)N/(Al,In,Ga)N, qui comprend les étapes suivantes :

i) fournir une structure 100 comprenant un substrat de base 110 recouvert de mésas 120 (Al,In,Ga)N/(Al,In,Ga)N, des lignes électriquement conductrices 200 recouvertes par un élément électriquement isolant 300 étant disposées sur le substrat de base 110 entre des groupes de mésas ou entre les mésas 120 (figure 3A),

ii) porosifier les mésas 120 (figure 3B),

iii) éventuellement retirer l'élément électriquement isolant 300 ou retirer les lignes électriquement conductrices 200 et l'élément isolant 300 (figure 3C).

L'utilisation de lignes électriquement conductrices 300 positionnées entre les mésas 120 permet d'obtenir une structure dans laquelle chaque mésa 120 a une configuration électrique équivalente (la perte de potentiel est suffisamment faible entre les mésas). La polarisation des mésas 120 est homogène conduisant à un bon contrôle de la porosification des mésas sur chaque motif. Le procédé permet non seulement de porosifier de manière identique (ou homogène) toutes les mésas 120 sur la plaque, qu'elles soient en bord ou au centre de la plaque mais également de porosifier tout le volume de de la couche dopée des mésas 120. Il est également possible de contrôler la porosification des mésas 120 afin de laisser, pour chaque mésa 120, une zone centrale non porosifiée formant un canal de conduction électrique au sein des mésas.

Il n'y a pas d'effets bord-centre pour la porosification. Le procédé est parfaitement adapté à des motifs ayant des dimensions supérieures à 5 $\mu$m et/ou pour de grands substrats (typiquement sur des substrats d'au moins 5 cm et de préférence d'au moins 10cm de diamètre).

De plus, la couche supérieure du substrat 110 en contact avec les lignes électriquement conductrices 200 peut avoir un dopage moindre puisque la conduction électrique se fait au moyen des lignes électriquement conductrices 200. Ainsi, non seulement la couche est moins exposée à une porosification non voulue mais en plus la couche est moins stressée.

Avec un tel procédé, la structure obtenue présente une bonne qualité cristalline. Il n'y a pas de risque de porosification des couches sous-jacentes à cause des défauts en pieds de mésa. Des couches ré-épitaxiées peuvent être facilement déposées sur la structure sans risque de contrainte conduisant à la formation de cracks. L'épaisseur ré-épitaxiée totale peut être élevée.

Ces lignes sont recouvertes d'un élément électriquement isolant qui les recouvre complètement et évite qu'elles ne soient en contact avec l'électrolyte durant l'étape de porosification. Ainsi, les lignes ne sont pas endommagées durant cette étape ; il n'y a pas de perte de conductivité.

Nous allons maintenant décrire plus en détail les différentes étapes du procédé.

Comme représenté sur la figure 3A et sur la figure 4, le substrat de base 110 de la structure 100 fournie à l'étape i) comprend successivement :

- une couche support 114,
- éventuellement une couche tampon en (Al,Ga)N, notamment dans le cas d'une couche support 114 en silicium,
- une première couche de GaN non dopée 111,
- une deuxième couche de GaN dopée 112.

Les mésas 120 (Al,In,Ga)N/(Al,In,Ga)N comprennent une troisième couche de (Al,In,Ga)N fortement dopée 123 et une quatrième couche de (Al,In,Ga)N non dopée ou faiblement dopée 124.

A l'issue de l'étape ii) de porosification, la troisième couche de (Al,In,Ga)N 123' des mésas est porosifiée au moins en partie (i.e. en partie ou totalement).

Une partie 112b de la deuxième couche de GaN dopée 112 se prolonge dans les mésas 120. L'autre partie 112a de la deuxième couche de GaN dopée 112 forme la partie supérieure du substrat du base 110. Cette partie est en contact direct avec les lignes électriquement conductrices 200. Autrement dit, il n'y a pas d'élément entre la partie 112a de la deuxième couche de GaN dopée 112 et les lignes électriquement conductrices 200. La partie 112a de la deuxième couche de GaN dopée 112 forme le fond des mésas.

Le fond des mésas est, de préférence, préservé de la porosification lors de l'étape ii).

La structure 100 fournie à l'étape i) est, par exemple, obtenue en fournissant puis gravant localement un empilement comprenant successivement :

- une couche support 114,
- éventuellement, une couche tampon en (Al,Ga)N, notamment dans le cas d'une couche support 114 en silicium,
- une première couche de nitrure de de gallium GaN non dopée 111,
- une deuxième couche de GaN dopée (GaN n) 112,
- une troisième couche de GaN fortement dopée (GaN n+ ou GaN nn) 123, et
- une quatrième couche en AlN, InGaN ou GaN (noté (Al,In,Ga)N) non intentionnellement dopée (nid) ou faiblement dopée 124.

De préférence, l'empilement est constitué des couches précédemment citées. Autrement dit, il ne comporte pas d'autres couches.

La couche support 114 est, par exemple en saphir ou en silicium.

La couche support 114 a, par exemple, une épaisseur allant de 250$\mu$m à 2mm. L'épaisseur dépend de la nature de la couche support 114 et de ses dimensions. Par exemple, pour une couche support en saphir de 2 pouces de diamètre, l'épaisseur peut être de 350 $\mu$m. Pour une couche support en saphir de 6 pouces de diamètre, l'épaisseur peut être de 1,3mm. Pour une couche support en silicium de 200mm de diamètre, l'épaisseur peut être 1mm.

Par « de X à Y », on entend que la valeur est comprise entre X et Y, les bornes étant incluses.

Dans le cas d'une couche support 114 en silicium, une couche tampon ('buffer') en (Al,Ga)N est, avantageusement, interposée entre la couche support 114 et la couche nid GaN 111.

La première couche 111 est une couche en GaN nid. C'est une couche non intentionnellement dopée (nid) pour ne pas être porosifiée. Par GaN non intentionnellement dopée, on entend une concentration inférieure à $1^e17at/cm^3$.

La première couche 111 en GaN nid a, par exemple, une épaisseur allant de 500nm à 5$\mu$m. Avantageusement, son épaisseur est entre 1 et 4 $\mu$m pour absorber les contraintes liées au désaccord de maille entre le GaN et le substrat.

La deuxième couche 112 est une couche en GaN dopée. Par GaN dopée, on entend une concentration, de préférence supérieure à $1.10^{17}$ at/cm$^3$ et de préférence inférieure à $5.10^{18}$ at/cm$^3$ et encore plus préférentiellement inférieure à $1.10^{18}$ at/cm$^3$. La présence des lignes électriquement conductrices permet d'avoir une couche de GaN dont la concentration est inférieure $5.10^{17}$ at/cm$^3$ et, par exemple entre $1.10^{17}$ at/cm$^3$ et $5.10^{17}$ at/cm$^3$.

La deuxième couche 112 en GaN a, par exemple, une épaisseur allant de 200nm à 1$\mu$m, préférentiellement entre 400 et 700nm. L'épaisseur minimale varie en fonction du taux de dopage.

La troisième couche 123 est une couche de GaN fortement dopée. Par GaN fortement dopée, on entend une concentration supérieure à $5.10^{18}$ at/cm$^3$, de préférence supérieure à $8.10^{18}$ at/cm$^3$, voire supérieure à $10^{19}$ at/cm$^3$. Elle a, par exemple, un dopage dix fois plus élevé que la deuxième couche 112. Elle a une épaisseur comprise entre 200nm et 2 $\mu$m, de préférence de 500 nm à 1$\mu$m. De préférence, le dopage de la troisième couche 123 est supérieur d'un facteur 30 voire d'un facteur 100 au dopage de la deuxième couche 112.

La quatrième couche 124 est une couche (Al,In,Ga)N non intentionnellement dopée ou faiblement dopée. Par (Al,In,Ga)N faiblement dopé, on entend un dopage entre $1.10^{17}$ at/cm$^3$ et $5.10^{17}$ at/cm$^3$. Par non dopée, on entend un taux de dopage inférieur à $1.10^{17}$at/cm$^3$.

Il peut s'agir d'une couche en AlN, AlGaN, InGaN ou GaN. Elle a par exemple une épaisseur entre 10nm et 200nm, de préférence entre 50 et 200nm. Le dopage est suffisamment faible de manière à ce que cette couche soit électriquement isolante. Elle n'est pas porosifiée lors de l'étape d).

Cette couche 124 n'est pas ou peu impactée par la porosification et sert de couche de nucléation pour une reprise de croissance. Cette couche 124 est continue pour assurer la qualité de la couche répitaxiée, d'une couche d' (In,Ga)N par exemple, sur la structure.

Les dopages des différentes couches précitées, et notamment de la deuxième couche 112 et de la troisième couche 123 seront choisis en fonction de la tension appliquée lors de la porosification.

En particulier, les taux de dopage respectifs sont choisis pour qu'à potentiel donné, il y ait une sélectivité entre la zone fortement dopée et la zone faiblement dopée. Pour un potentiel donné, le taux de dopage de la deuxième couche 112 est choisi de manière à ce que la deuxième couche 112 ne soit pas porosifiée lors de l'étape d) et le taux de dopage de la troisième couche 123 est choisi de manière à ce que la troisième couche 123 soit porosifiée lors de l'étape d).

Par la suite, on décrit un dopage de type n, mais il pourrait s'agir d'un dopage de type p.

L'empilement précédemment décrit est structuré pour former les mésas 120, par exemple, par photolithographie.

Les mésas 120, aussi appelées élévations, sont des éléments en relief. Elles sont obtenues, par exemple, par gravure d'une couche continue ou de plusieurs couches continues superposées, de manière à ne laisser subsister qu'un certain nombre de "reliefs" de cette couche ou de ces couches. La gravure est, de préférence, réalisée avec un masque dur qui présente une sélectivité favorable avec la vitesse de gravure des couches de GaN (typiquement avec un rapport de vitesse de gravure > 1/4). Le masque dur est, par exemple, en SiO$_2$. Après gravure des mésas, ce masque dur est retiré par un procédé chimique humide avant porosification. Il est également possible de retirer ce masque dur après porosification, en le dégageant uniquement, dans les zones servant à la polarisation électrochimique. Avantageusement, le masque est retiré avant l'étape de porosification.

De préférence, les flancs des mésas 120 sont perpendiculaires à cet empilement de couches.

La surface des mésas peut être circulaire, hexagonale, carrée ou rectangulaire.

La plus grande dimension de la surface des mésas 120 va de 500nm à 500pm. Par exemple, la plus grande dimension d'une surface circulaire est le diamètre.

L'épaisseur des mésas correspond à la dimension de la mésa perpendiculaire à l'empilement sous-jacent.

L'espacement entre deux mésas 120 consécutives peut aller de quelques micromètres à quelques dizaines de micromètres. L'espacement va, de préférence, de 50nm à 20$\mu$m. Il est, par exemple, de 5 $\mu$m. Encore plus préférentiellement, il est compris entre 1 et 2pm.

Les mésas 120 peuvent avoir des dopages identiques ou différents. Plus le taux de dopage est élevé, et plus la porosification sera importante à potentiel fixe. La relaxation de la quatrième couche 124 de (Al,In,Ga)N dense dépend du taux de porosification des mésas. Ainsi, des quantités différentes d'indium pourront être intégrées lors de la ré-épitaxie d'InGaN sur la couche dense 124 (grâce à la réduction du « compositionnal pulling effect » (i.e. du poussage des atomes d'In vers la surface, les empêchant de s'incorporer dans la couche). On obtiendra ainsi, après épitaxie de la structure LED complète, des mésas bleues, vertes et rouges (RGB) sur un même substrat, et en une seule étape de croissance, si l'écart entre les niveaux de relaxation des mésas est suffisant.

Les mésas 120 sont formées en gravant l'empilement, et plus particulièrement, en gravant la quatrième couche 124, la troisième couche 123 et une première partie 112a de la deuxième couche dopée 112. En arrêtant la gravure dans la couche dopée, toute la hauteur de la troisième couche n++ 123 est disponible pour la relaxation.

Ainsi, on obtient une structure 100 comprenant un substrat de base 110 surmonté d'une pluralité de mésas 120 en (Al,In,Ga)N/(Al,In,Ga)N.

Chaque mésa 120 comprend successivement depuis la base : la deuxième partie 112b de la couche de GaN dopée 112, la troisième couche de GaN fortement dopée 123 et la quatrième couche de (Al,In,Ga)N non dopée ou faiblement dopée 124.

A titre illustratif et non limitatif, la structure 100 peut comprendre :

- un substrat de base 110 comprenant successivement : une couche support 114 en saphir ou en silicium, éventuellement une couche tampon en (Al,Ga)N, une première couche 111 de GaN non dopée de $4\mu m$, une première partie 112a de la deuxième couche 112 de GaN dopée de 500nm ($1.10^{18}$ at/cm3),
- des mésas 120 (Al,In,Ga)N/(Al,In,Ga)N comprenant successivement : une deuxième partie 112b de la deuxième couche 112 de GaN dopée de 100nm ($1.10^{18}$ at/cm$^3$), une troisième couche 123 de GaN fortement dopée de 800 nm ($1.10^{19}$ at/cm$^3$), et une couche de nid (Al,In,Ga)N de 100nm.

La structure 100 comprend, en outre, des lignes électriquement conductrices 200 positionnées entre les mésas 120, sur le substrat de base 110. Lors de la porosification, les charges passent par les lignes électriquement conductrices 200 et sont injectées à proximité de chaque mésa 120. La distance entre les lignes électriquement conductrices 200 et les mésas 120 sera choisie à être suffisamment faible de manière à éviter la porosification de la deuxième couche 112 dopée. Elle pourra être adaptée pour contrôler le taux de porosification souhaité des mésas.

Par électriquement conductrices, on entend une conductivité pouvant permettre, par exemple, une densité de courant de l'ordre de 8mA /cm$^2$.

Les lignes électriquement conductrices 200 suivent le fond des mésas 120. Les lignes électriquement conductrices 200 peuvent être des lignes droites (notamment dans le cas de mésas carrées) ou des lignes brisées (par exemple dans le cas de mésas hexagonales).

Les lignes électriquement conductrices 200 forment, avantageusement, une grille, c'est-à-dire que les lignes se croisent. Chaque mésa 120 est, avantageusement, positionnée à côté d'une ou plusieurs lignes électriquement conductrices 200. Par à côté, on entend qu'au moins un espace inter-mésa adjacent à une mésa 120 est recouvert par une ligne électriquement conductrice 200. De préférence, au moins deux espaces et encore plus préférentiellement au moins quatre (par exemple six) espaces inter-mésas adjacents à une mésa sont recouverts par des lignes.

Il est également possible de positionner les lignes électriquement conductrices 200 autour de groupes formés de plusieurs mésas. Il est, par exemple, possible de former des groupes de 4 mésas ou plus.

Les lignes électriquement conductrices 200 peuvent recouvrir localement ou totalement le fond des mésas. Elles ne font pas partie des mésas 120 ni du substrat de base 110.

Les lignes électriquement conductrices 200 ont une largeur, par exemple, comprise entre 750 nm et 2 $\mu m$.

La largeur des lignes électriquement conductrices 200 est choisie en fonction de l'espace entre les mésas. Par exemple, pour un espace inter mésas ('trench') de 1,5$\mu m$, des lignes de 1 $\mu m$ de largeur pourront être choisies.

L'épaisseur des lignes électriquement conductrices 200 est, par exemple, comprise entre 100 et 200 nm.

Les dimensions et l'épaisseur seront choisies en fonction du matériau et de la conductivité recherchée.

Les lignes électriquement conductrices 200 recouvrent localement le substrat de base 110 et l'espace entre les lignes électriquement conductrices 200 et les mésas 120 est compris entre 100 nm et 1 $\mu m$, de préférence entre 200 nm et 500 nm.

Selon un premier mode de réalisation avantageux, les lignes électriquement conductrices 200 sont en métal, par exemple choisi parmi le titane et l'aluminium. De préférence, les lignes électriquement conductrices 200 sont en titane.

Selon une deuxième variante de réalisation, les lignes électriquement conductrices 200 sont en (Al,In,Ga)N fortement dopé, de préférence en GaN fortement dopé. Par fortement dopé, on entend une concentration supérieure à $5.10^{18}$ at/cm$^3$.

Selon une troisième variante de réalisation, les lignes électriquement conductrices 200 sont en un polymère électriquement conducteur.

Les lignes électriquement conductrices 200 sont recouvertes par un élément électriquement isolant 300. L'élément électriquement isolant 300 est chimiquement inerte dans la solution utilisée pour la porosification. L'élément électriquement isolant 300 recouvre totalement les lignes électriquement conductrices 200 afin qu'elles ne soient pas en contact avec l'électrolyte lors de l'étape de porosification. L'élément électriquement isolant 300 n'est pas porosifié. L'élément électriquement isolant 300 est, de préférence, un matériau diélectrique. Par exemple, l'élément électriquement isolant 300 est en oxyde de silicium ($SiO_2$) ou en nitrure de silicium ($Si_3N_4$). Il peut également être en un polymère, par exemple un polymère photosensible.

Selon la nature des lignes électriquement conductrices 200, plusieurs étapes de fabrication peuvent être mises en oeuvre.

A titre illustratif, deux variantes de réalisation pour former des lignes électriquement conductrices 200 en métal vont être décrites.

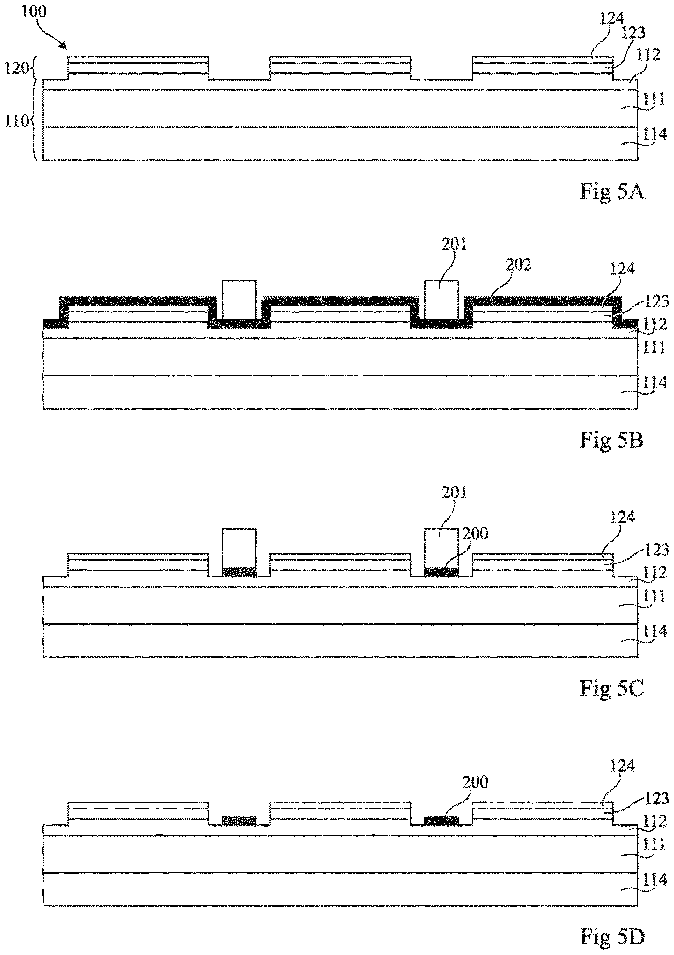

Les figures 5A à 5D représentent une première variante de réalisation. La première variante de réalisation comprend les étapes suivantes :

- fournir la structure 100 (figure 5A),
- former une couche en métal 202 pleine plaque (i.e. la couche en métal 202 recouvre les mésas 120 et l'espace entre les mésas 120), puis déposer une résine 201 entre les mésas 120, la couche de résine 201 ayant la forme de lignes que l'on souhaite former (figure 5B),
- graver la couche en métal 202 non recouverte par la couche de résine 201 (figure 5C),
- retirer la résine 201 (« stripping »), moyennant quoi on obtient des lignes électriquement conductrices 200 en métal localisées entre les mésas 120 (figure 5D).

La résine 201 définit le motif de grille. Elle peut être formée par photolithographie ou par sérigraphie.

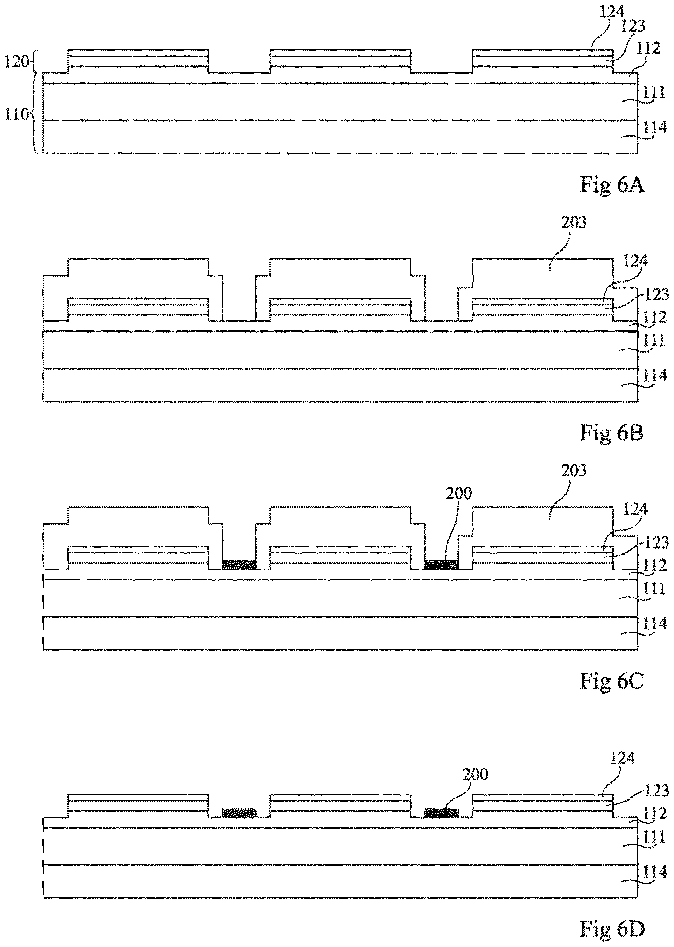

Les figures 6A à 6D représentent une deuxième variante de réalisation. La deuxième variante de réalisation comprend les étapes suivantes :

- fournir la structure 100 (figure 6A),
- former par lithographie une couche de résine 203 sur les mésas 120 et localement entre les mésas 120, de manière à avoir une zone entre les mésas non recouverte par la résine 203, la zone non recouverte ayant une forme de lignes, notamment de lignes qui se croisent, de préférence une forme de grille (figure 6B),
- déposer une couche métallique 200 sur la zone non recouverte par la résine 203, la couche métallique 200 ayant ainsi la forme de lignes, de préférence une forme de grille (figure 6C),
- retirer la résine 203 (« lift off métal par stripping »), moyennant quoi on obtient des lignes électriquement conductrices 200 en métal localisées entre les mésas 120 (figure 6D).

La couche métallique peut être déposée pleine plaque.

Selon une autre variante non représentée, les lignes électriquement conductrices 200 sont en polymère conducteur. Le polymère conducteur peut être déposé par sérigraphie, lithographie (insolation-développement), ou par tout autre moyen permettant de former des lignes avec ce matériau.

Après porosification, les lignes électriquement conductrices 200 en polymère conducteur peuvent être retirées par gravure humide et/ou par gravure sèche.

Quelle que soit la variante de réalisation mise en oeuvre, un élément électriquement isolant 300 est ensuite déposé sur les lignes électriquement conductrices 200 afin de les protéger lors de l'étape d'anodisation.

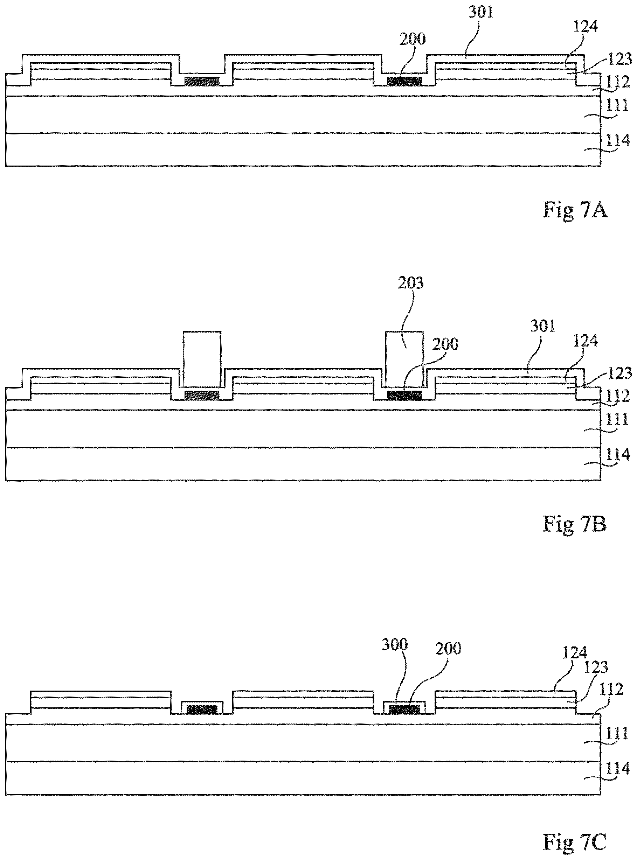

Pour cela, comme représenté sur les figures 7A à 7C, il est possible de réaliser les étapes suivantes :

- déposer pleine plaque une couche électriquement isolante 301 (figure 7A),
- déposer localement une résine 203 en regard des lignes électriquement conductrices 200 (figure 7B),
- graver la couche électriquement isolante 301 non recouverte par la résine 203, puis retirer la résine 203 (figure 7C).

Pour réaliser des lignes électriquement conductrices 200 en GaN dopé (typiquement un taux de dopage supérieur à $1.10^{18}$ at/cm$^3$), on pourra, par exemple, former une zone de croissance sélective (ou SAG pour « Sélective Area Growth »). La zone de croissance est délimitée par une couche SAG en un matériau défavorable à la croissance du GaN. La couche SAG recouvre les mésas 120 et recouvre localement l'espace entre les mésas. La couche de SAG présente une ouverture en forme de lignes, de préférence sous forme de grille, délimitant une zone non couverte sur laquelle on souhaite former la grille en GaN dopé. La couche en SAG a une forme complémentaire de la grille.

Par défavorable à la croissance du GaN, on entend que le GaN ne peut pas croître sur cette couche ou que la cinétique de croissance du GaN sur ce matériau est très lente par rapport à la cinétique de croissance du GaN sur le matériau accessible à travers les ouvertures de la couche SAG (i.e. le matériau de l'espace intermésas, c'est-à-dire le matériau formant la deuxième couche 112 : le GaN dopé).

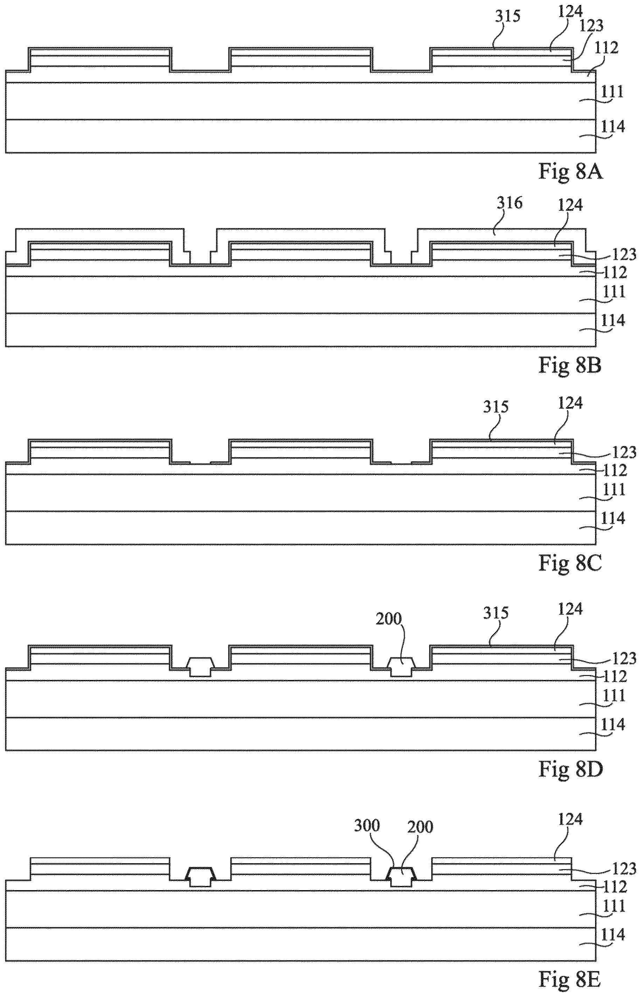

Plus particulièrement pour former des lignes électriquement conductrices 200 en GaN dopé, il est possible de réaliser les étapes suivantes (figures 8A à 8D) :

- déposer pleine plaque une couche 315 en un matériau défavorable à la croissance du GaN, par exemple un nitrure ou un oxyde, notamment un nitrure de silicium et/ou un oxyde de silicium (figure 8A),
- déposer localement une résine 316 par lithographie, de manière à laisser accessible une partie de la couche 315 en matériau défavorable à la croissance du GaN entre les mésas(figure 8B),

- puis graver ledit matériau 315, et retirer la résine 316, moyennant quoi on obtient une zone de croissance sélective ayant la forme de lignes entre les mésas (figure 8C),

- réaliser une épitaxie de GaN dopé n+ pour former des lignes électriquement conductrices 200 en GaN dopé n+ entre les mésas (figure 8D).

La couche 315 est ensuite retirée.

Comme précédemment, un élément électriquement isolant 300 est ensuite déposé sur les lignes électriquement conductrices 200 afin de les protéger lors de l'étape d'anodisation (figure 8E). Par exemple, les étapes précédemment décrites représentées, notamment sur les figures 7A à 7C peuvent être réalisées.

En particulier, il peut s'agir des étapes suivantes :

- déposer pleine plaque une couche électriquement isolante (par exemple, en un matériau diélectrique),

- déposer localement une résine en regard des lignes électriquement conductrices,

- graver la couche électriquement isolante non recouverte par la résine,

- retirer la résine.

Lors de l'étape ii), la structure est porosifiée. La porosification peut être réalisée selon les sous-étapes suivantes :

- relier électriquement la structure 100 et une contre-électrode à un générateur de tension ou de courant,

- plonger la structure 100 et la contre-électrode dans une solution électrolytique,

- appliquer une tension ou un courant entre la deuxième couche de GaN dopée 112 et la contre-électrode de manière à porosifier la troisième couche de (Al,In,Ga)N fortement dopée 123 des mésas 120.

La structure 100 et une contre-électrode (CE) sont électriquement reliées à un générateur de tension ou de courant. Le dispositif joue le rôle d'électrode de travail (WE). Par la suite, on le dénommera générateur de tension, mais il pourrait s'agir d'un générateur de courant permettant d'appliquer un courant entre le dispositif et la contre-électrode.

La prise de contact est réalisée sur la structure 100.

En particulier, la prise de contact peut être réalisée sur le substrat de base 110. La reprise de contact peut être réalisée sur la deuxième couche de GaN dopée 112. La reprise de contact peut être faite sur le fond des mésas, au niveau de la deuxième couche 112, ce qui permet d'utiliser l'étape de gravure pour réaliser également les prises de contact. Alternativement, il est possible de réaliser la reprise de contact sur les lignes électriquement conductrices 200.

Il est également possible de prendre contact sur une des autres couches : sur la quatrième couche de (Al,In,Ga)N faiblement dopée 124 ou sur la troisième couche de (Al,In,Ga)N fortement dopée 123. Dans le cas d'une reprise de contact sur la couche fortement dopée, son ouverture sera, avantageusement, limitée à une zone préservée de l'électrolyte.

La zone de reprise de contact peut également être surmontée d'une couche métallique afin d'améliorer le contact pour la polarisation électrochimique. Ce contact pourra être retiré après la porosification avant la reprise d'épitaxie.

La contre-électrode est en un matériau électriquement conducteur, comme par exemple un métal de grande surface développée et inerte à la chimie de l'électrolyte tel qu'un grillage en platine.

Les électrodes sont plongées dans un électrolyte, aussi appelé bain électrolytique ou solution électrolytique. L'électrolyte peut être acide ou basique. L'électrolyte est, par exemple, de l'acide oxalique. Il peut également s'agir de KOH, HF, $HNO_3$, $NaNO_3$ ou $H_2SO_4$.

La tension appliquée entre la structure 100 et la contre-électrode peut aller de 1 à 30V par exemple. De préférence, elle est de 5 à 15V, et encore plus préférentiellement de 6 à 12V, par exemple de 8 à 10V. La tension est choisie en fonction des taux de dopage des différentes couches, afin d'obtenir la sélectivité recherchée. Elle est appliquée, par exemple, pendant une durée allant de quelques secondes à plusieurs heures. La porosification est complète lorsqu'il n'y a plus de courant à un potentiel imposé. A ce moment-là, toute la structure dopée est porosifiée et la réaction électrochimique s'arrête.

Par exemple, l'étape de porosification est réalisée en appliquant une tension de 9V (non pulsée) dans une solution d'acide oxalique. L'arrêt du processus est contrôlé avec la chute de courant.

L'étape d'anodisation électrochimique peut être réalisée sous lumière ultra-violette (UV).

Avantageusement, la porosification a lieu dans tout le volume de la troisième couche de GaN fortement dopé 123.

Selon un autre mode de réalisation avantageux, seule une partie du volume de la troisième couche de GaN fortement dopé 123 est porosifiée. Il est possible d'arrêter l'étape de porosification avant d'avoir complètement porosifié la troisième couche de GaN fortement dopé 123. Il est, par exemple, possible de laisser ainsi un canal conducteur au centre des mésas.

A l'issue de l'étape de porosification, le taux de porosité de la troisième couche de GaN fortement dopée 123 est, avantageusement, d'au moins 10%. Il va de préférence de 25% à 70%, de préférence de 25% à 50%, par exemple de 45% à 50%.

La plus grande dimension (la hauteur) des pores peut varier de quelques nanomètres à quelques micromètres. La plus petite dimension (le diamètre) peut varier de quelques nanomètres à une centaine de nanomètres, en particulier de 30 à 70nm.

La porosification obtenue (taux de porosité et taille des pores) dépend du dopage de la couche et des paramètres du procédé (tension appliquée, durée, nature et concentration de l'électrolyte, post-traitement chimique ou recuit). La variation de la porosification permet de contrôler le taux d'incorporation / ségrégation.La porosification, et en particulier, la taille des pores, pourra varier ultérieurement, lors de la reprise d'épitaxie en fonction de la température appliquée.

Les mésas 120 d'une même plaque sont ainsi porosifiées, que ce soit pour des substrats de faibles ou moyennes dimensions ou pour des substrats de grandes dimensions.

Les pieds des mésas sont intègres.

La structure obtenue est représentée sur la figure 3B et sur la figure 4.

Le procédé peut comporter une étape iii) au cours de laquelle les lignes électriquement conductrices ainsi que l'élément électriquement isolant sont retirés (figure 3C).

Avantageusement, les lignes électriquement conductrices sont retirées lorsqu'elles sont en métal ou en polymère conducteur. Ceci évite toute contamination lors d'une reprise d'épitaxie ultérieure.

Selon une variante de réalisation avantageuse, les lignes sont en GaN dopé et elles sont conservées. Il est possible de conserver ou de retirer l'élément isolant. La présence des lignes électriquement conductrices est particulièrement avantageuse dans le cas d'une structure de type grande dimension. Elles pourront, avantageusement, avoir un rôle dans le dispositif final, par exemple, dans le fonctionnement d'un écran (« display ») de grande dimension. En effet, cela permet de ne pas avoir de perte de potentiel entre le bord et le centre et d'avoir une couche de reprise de contact homogène sur toute la surface de la structure.

Avantageusement, le procédé comprend une étape iv) ultérieure au cours de laquelle on réalise une épitaxie sur les mésas 120, moyennant quoi on obtient une couche épitaxiée au moins partiellement relaxée, et de préférence totalement relaxée.

Le pourcentage de relaxation correspond à :

$$\underline{\Delta a / a} = (a_{c2} - a_{c1}) / a_{c1}$$

avec $a_{c1}$, le paramètre de maille de la couche de départ sur laquelle on reprend l'épitaxie (c'est-à-dire le paramètre de maille de la couche 124), et

$a_{c2}$ le paramètre de maille de la couche relaxée,

La couche est relaxée à 100% si $ac_2$ correspond au paramètre de maille du matériau massif, de même composition que la couche réépitaxiée.

Lorsque $a_{c1} = a_{c2}$ la couche est dite contrainte.

Par partiellement relaxée, on entend un pourcentage de relaxation supérieur à 50%.

La reprise d'épitaxie peut servir, par exemple, pour former des LED ré-épitaxiées.

La reprise d'épitaxie est réalisée sur la quatrième couche 124 de (Al,In,Ga)N/(Al,In,Ga)N nid ou faiblement dopée des mésas 120. Comme cette couche n'est pas porosifiée lors de l'étape d'anodisation électrochimique, elle reste continue et dense. La reprise d'épitaxie est ainsi facilitée et la couche épitaxiée présente une meilleure tenue. La création de défauts liées à la coalescence des pores est évitée.

La couche épitaxiée lors de cette étape iv) est, avantageusement, en nitrure de gallium ou en nitrure d'indium et de gallium.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en oeuvre pratique des modes de réalisation et variantes décrits est à la portée de la personne du métier à partir des indications fonctionnelles données ci-dessus.

## Revendications

1. Procédé de porosification d'une structure (100) comprenant un substrat de base (110) recouvert de mésas (120) (Al,In,Ga)N/(Al,In,Ga)N, comprenant une étape de porosification au cours de laquelle on porosifie par voie électrochimique les mésas (Al,In,Ga)N/(Al,In,Ga)N **caractérisé en ce que**, lors de l'étape de porosification, des lignes électriquement conductrices (200) recouvertes par un élément électriquement isolant (300) sont disposées sur le substrat de base (110) entre les mésas (120) ou entre des groupes de mésas (120).

2. Procédé selon la revendication 1, **caractérisé en ce que** le substrat de base (110) comprend une couche support (114), une première couche de GaN non dopée (111), une deuxième couche de GaN dopée (112),

   les mésas (120) (Al,In,Ga)N/(Al,In,Ga)N comprenant une troisième couche de (Al,In,Ga)N fortement dopée (123) et une quatrième couche de (Al,In,Ga)N non dopée ou faiblement dopée (124),
   une partie (112b) de la deuxième couche de GaN dopée (112) se prolongeant dans les mésas (120),
   lors de l'étape de porosification, les lignes électriquement conductrices (200) étant en contact direct avec la deuxième couche de GaN dopée (112) la troisième couche de (Al,In,Ga)N fortement dopée (123) étant porosifiée lors de l'étape de porosification.

3. Procédé selon l'une des revendications 1 et 2, **caractérisé en ce que** les lignes électriquement conductrices (200) sont en un métal, de préférence en titane, ou en un polymère conducteur.

4. Procédé selon l'une des revendications 1 et 2, **caractérisé en ce que** les lignes électriquement conductrices (200) sont en GaN fortement dopé.

5. Procédé selon la revendication précédente, **caractérisé en ce que** le procédé comprend une étape au cours de laquelle les lignes électriquement conductrices (200) sont formées par épitaxie.

6. Procédé selon l'une quelconque des revendications précédentes, **caractérisé en ce que** les lignes électriquement conductrices (200) forment une grille.

7. Procédé selon l'une quelconque des revendications précédentes, **caractérisé en ce que** les lignes électriquement conductrices (200) recouvrent localement le substrat de base (110) et **en ce que** l'espace entre les lignes électriquement conductrices (200) et les mésas (120) est compris entre 100 nm et 1 $\mu$m, de préférence entre 200 nm et 500 nm.

8. Structure (100) comprenant un substrat de base (110) recouvert de mésas (120) (Al, In,Ga)N/ (Al, In,Ga)N porosifiées,
la structure (100) comprenant, en outre, des lignes électriquement conductrices (200), recouvertes par un élément électriquement isolant (300), disposées sur le substrat de base (110) entre les mésas (120) ou entre des groupes de mésas (120).

9. Structure (100) selon la revendication 8, **caractérisée en ce que** le substrat de base (110) comprend une couche support (114), une première couche de GaN non dopée (111) et une deuxième couche de GaN dopée (112),

les mésas (120) (Al,In,Ga)N/(Al,In,Ga)N comprenant une troisième couche de GaN fortement dopée porosifiée (123) et une quatrième couche de (Al,In,Ga)N non dopée ou faiblement dopée (124),
une partie (112a) de la deuxième couche de GaN dopée (112) se prolongeant dans les mésas (120).

10. Structure selon l'une des revendications 8 et 9, **caractérisé en ce que** les lignes électriquement conductrices (200) sont en GaN fortement dopé, en métal ou en polymère conducteur.

Fig 1A
(art antérieur)

Fig 1B
(art antérieur)

Fig 1C
(art antérieur)

1 µm

Fig 2A
(art antérieur)

Fig 2B
(art antérieur)

Fig 3A

Fig 3B

Fig 3C

Fig 4

Fig 5A

Fig 5B

Fig 5C

Fig 5D

Fig 6A

Fig 6B

Fig 6C

Fig 6D

Fig 7A

Fig 7B

Fig 7C

Fig 8A

Fig 8B

Fig 8C

Fig 8D

Fig 8E

Europäisches
Patentamt

European
Patent Office

Office européen
des brevets

## RAPPORT DE RECHERCHE EUROPEENNE

Numéro de la demande

EP 24 19 7444

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 2022/406968 A1 (DUPRE LUDOVIC [FR] ET AL) 22 décembre 2022 (2022-12-22) | 8-10 | INV.<br>H10H29/01 |
| A | * figures 1A-1J *<br>* alinéas [0074] - [0113] * | 1-7 | H10H20/815<br>H10H29/30 |
| | ----- | | H10H20/817 |
| X | US 2021/193870 A1 (PERNEL CAROLE [FR] ET AL) 24 juin 2021 (2021-06-24) | 8-10 | |
| A | * figures 1A,1B *<br>* alinéas [0072] - [0112] * | 1-7 | |
| | ----- | | |

DOMAINES TECHNIQUES
RECHERCHES (IPC)

H01L
H10H

Le présent rapport a été établi pour toutes les revendications

| Lieu de la recherche | Date d'achèvement de la recherche | Examinateur |
|---|---|---|
| La Haye | 3 février 2025 | Adams, Richard |

CATEGORIE DES DOCUMENTS CITES

X : particulièrement pertinent à lui seul
Y : particulièrement pertinent en combinaison avec un
  autre document de la même catégorie
A : arrière-plan technologique
O : divulgation non-écrite
P : document intercalaire

T : théorie ou principe à la base de l'invention
E : document de brevet antérieur, mais publié à la
  date de dépôt ou après cette date
D : cité dans la demande
L : cité pour d'autres raisons

...................................................................................
& : membre de la même famille, document correspondant

EPO FORM 1503 03.82 (P04C02)

**EP 4 521 891 A1**

## ANNEXE AU RAPPORT DE RECHERCHE EUROPEENNE
## RELATIF A LA DEMANDE DE BREVET EUROPEEN NO.

EP 24 19 7444

03-02-2025

| Document brevet cité au rapport de recherche | Date de publication | Membre(s) de la famille de brevet(s) | | Date de publication |
|---|---|---|---|---|
| US 2022406968 A1 | 22-12-2022 | CN | 115483321 A | 16-12-2022 |
| | | EP | 4105999 A1 | 21-12-2022 |
| | | FR | 3124313 A1 | 23-12-2022 |
| | | US | 2022406968 A1 | 22-12-2022 |
| US 2021193870 A1 | 24-06-2021 | CN | 113013304 A | 22-06-2021 |
| | | EP | 3840065 A1 | 23-06-2021 |
| | | EP | 4418308 A2 | 21-08-2024 |
| | | FR | 3105567 A1 | 25-06-2021 |
| | | US | 2021193870 A1 | 24-06-2021 |
| | | US | 2023369541 A1 | 16-11-2023 |

EPO FORM P0460

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **PASAYAT et al.** *Materials*, 2020, vol. 13, 213
- *Appl. Phys. Lett.*, 2020, vol. 116, 111101